# EUROPÄISCHE PATENTANMELDUNG

(11) **EP 3 043 383 A1**
(43) Veröffentlichungstag der Anmeldung: **13.07.2016**
(21) Anmeldenummer: 15000006.5
(22) Anmeldetag: 06.01.2015
(51) Int. Cl.: H01L 25/075, H01L 33/60, H01L 33/62, F21S 4/00, F21V 7/00, H05K 1/02

(54) **LED Lichtband und Verfahren zur Herstellung des LED Lichtbandes**

(71) Anmelder: Muessli, Daniel, 8957 Spreitenbach (CH)
(72) Erfinder: Muessli, Daniel, 8957 Spreitenbach (CH)
(74) Vertreter: Schaad, Balass, Menzl & Partner AG

(57) **Zusammenfassung**

Das erfindungsgemässe LED Lichtband (10A; 10B) weist ein eine Längsrichtung (L) definierendes Trägerband (12) mit einer Oberseite (14) und einer Unterseite (16) auf. Das Trägerband (12) ist thermisch leitfähig und mindestens auf der Oberseite (14) elektrisch isolierend. Weiter weist das LED Lichtband (10A; 10B) auf der Oberseite angeordnete Wannen (26) auf, welche auf der vom Trägerband (12) abgewandten Seite offen und reflektierend sind. Mindestens jeweils ein LED Chip (34) ist in den Wannen (26) angeordnet. Das LED Lichtband (10A; 10B) weist weiter elektrische Speiseleiterbahnen (58, 60) und Serienschaltungsleiterbahnen (41) auf, wobei die Serienschaltungsleiterbahnen (41) jeweils eine Anzahl der LED Chips (34) zwischen einer positiven und einer negativen Speiseleiterbahn (58, 60) in Serie schalten, und die Speiseleiterbahnen (58, 60) Speiseleiterbahnanschlüsse (56, 58) aufweisen, die dazu bestimmt sind, eine Verbindung mit einem Speisegerät zu ermöglichen. Weiter weist das LED Lichtband (10A; 10B) ein Leuchtstoffmaterial (44) auf, welches die Wellenlänge des emittierten Lichts der LED Chips (34) verändert und das LED Lichtband (10A; 10B) weist eine transluzente oder transparente Abdeckung (46) auf, welche die LED Chips (34) und das Leuchtstoffmaterial (44) vor äusseren Einflüssen schützt.

## Beschreibung

Die Erfindung betrifft ein LED Lichtband gemäss Patentanspruch 1 und ein Verfahren zur Herstellung des LED Lichtbandes gemäss Patentanspruch 15.

Dokument DE 10 2008 054 288 A1 offenbart eine flexible Leuchtvorrichtung und ein Verfahren zur Herstellung eines flexiblen Leuchtbandes. Die flexible Leuchtvorrichtung weist ein auf Biegung ausgelegtes und zur Bestückung mit Funktionsbauteilen in Form von Lichtquellen, insbesondere Leuchtdioden, und Treiberbauteile wie Widerstände, Kondensatoren, usw. zum Betreiben der Leuchtdioden vorgesehenes Substrat auf. Das Substrat ist mit einer Glasfaserverbundlage und mindestens einer Kupferlage hergestellt. Die Treiberbauteile zusammen mit den Leuchtdioden sind auf der Oberseite der Kupferlage des Substrats in Längsrichtung hintereinander in Reihe angeordnet und aneinander befestigt. Entsprechend ist zwischen zwei benachbarten Leuchtdioden ausreichend Platz für die Treiberbauteile vorgesehen. Da die Treiberbauteile selbst jedoch keine Leuchtwirkung aufweisen, leuchtet die bekannte Leuchtvorrichtung nur punktuell an jenen Stellen auf dem Leuchtband, wo die Leuchtdioden angeordnet sind. Entsprechend weist die bekannte Leuchtvorrichtung eine reduzierte Leuchtwirkung auf.

Es ist somit eine Aufgabe der vorliegenden Erfindung, ein LED Lichtband bzw. ein Verfahren zur Herstellung eines LED Lichtbandes zu schaffen, welches eine verbesserte Leuchtwirkung aufweist.

Die Aufgabe wird mit einem LED Lichtband bzw. einem Verfahren zur Herstellung des LED Lichtbandes gelöst, welches die Merkmale des Patentanspruchs 1 bzw. 15 aufweist.

Das erfindungsgemässe LED Lichtband gemäss Patentanspruch 1 weist ein eine Längsrichtung definierendes Trägerband mit einer Oberseite und einer Unterseite auf. Das Trägerband ist thermisch leitfähig und mindestens auf der Oberseite elektrisch isolierend. Weiter weist das LED Lichtband auf der Oberseite angeordnete Wannen auf, welche auf der vom Trägerband abgewandten Seite offen und reflektierend sind. Mindestens jeweils ein LED Chip ist in den Wannen angeordnet. Das LED Lichtband weist weiter elektrische Speiseleiterbahnen und Serienschaltungsleiterbahnen auf, wobei Serienschaltungsleiterbahnen jeweils eine Anzahl der LED Chips zwischen einer positiven und einer negativen Speiseleiterbahn in Serie schalten, und die Speiseleiterbahnen Speiseleiterbahnanschlüsse aufweisen, die dazu bestimmt sind, eine Verbindung mit einem Speisegerät zu ermöglichen. Weiter weist das LED Lichtband ein Leuchtstoffmaterial auf, welches die Wellenlänge des emittierten Lichts der LED Chips verändert und das LED Lichtband weist eine transluzente oder transparente Abdeckung auf, welche die LED Chips und das Leuchtstoffmaterial vor äusseren Einflüssen schützt.

In vorteilhafter Weise erlaubt die Anordnung des LED Chips in der nach oben offenen, reflektierenden Wanne eine optimale Lichtabstrahlung, da die Reflexionsflächen der Wanne das emittierte Licht des LED Chips in Richtung der Öffnung der Wanne ablenkt. Hierbei wird das emittierte Licht durch die Reflexionsflächen gebündelt und es kann eine erhöhte Lichtausbeute erreicht werden, da insbesondere das emittierte Licht an den Seitenwänden des LED Chips zusätzlich zum emittierten Licht auf der vom Trägerband abgewandten Seite mit genutzt wird. Somit wird mittels der reflektierenden Wanne erreicht, dass nicht nur eine punktuelle Stelle um den LED Chip herum leuchtet, sondern die gesamte reflektierende Wanne, was zu einer erheblich höheren Lichtwirkung führt.

Ein weiterer Vorteil des erfindungsgemässen LED Lichtbandes ist die mögliche Anordnung von Wannen direkt neben einander, so dass das vom LED Chip abgestrahlte Licht aus einer ersten reflektierenden Wanne mit dem Licht des LED Chips aus den benachbarten reflektierenden Wannen einen homogenen Gesamteindruck des abgestrahlten Lichtes ergibt. Dies führt erfindungsgemäss zu einem LED Lichtband mit einer sehr homogenen Lichtverteilung zusammen mit der oben erwähnten erhöhten Lichtwirkung im Sinne der Lichtausbeute pro LED Chip.

Ein weiterer Vorteil des erfindungsgemässen LED Lichtbandes ist, dass keine Treiberbausteine auf dem LED Lichtband selbst vorgesehen sein müssen bzw. sind, da die elektrischen Speiseleiterbahnen und Serienschaltungsleiterbahnen die Speisung der LED Chips von einem Speisegerät ermöglichen. Somit ist auf dem Trägerband ausreichend Platz um die Wannen für eine optimale Lichtwirkung auf der Oberseite des Trägerbandes direkt nebeneinander anzuordnen.

Die thermische Leitfähigkeit des Trägerbandes hat den Vorteil, dass die in den LED Chips erzeugte Wärme sehr effizient in Richtung des Trägerbandes und entsprechend an die Umgebung abgeführt werden kann. Dies hat den weiteren vorteilhaften Effekt, dass der LED Chip in der Wanne sich nicht zu sehr aufheizen kann, was ansonsten zu thermischen Defekten im LED Material und einer entsprechenden Reduktion der Lebensdauer des LED Chips führen könnte.

Die elektrisch isolierende Eigenschaft der Oberseite des Trägerbandes hat insbesondere den Vorteil, dass die Kriechstromfestigkeit (CTI-Wert) und die Durchschlagfestigkeit erhöht werden. Ausserdem dient die isolierende Oberseite des Trägerbandes als Korrosionsschutz für die auf der Oberseite des Trägerbandes in Reihe angeordneten Wannen.

Bevorzugt weist das Trägerband ein vorzugsweise aus Aluminium gebildetes Metallband und eine mit diesem fest verbundene, vorzugsweise durch ein Isolierband gebildete, die Oberseite bildende elektrische Isolationsschicht auf. In vorteilhafter Weise ist das Trägerband als Verbundsystem des Metallbandes zusammen mit dem Isolierband als Endlosband verfügbar. Auf diese Art und Weise kann das Trägerband im Reel-to-Reel Verfahren zum LED Lichtband bearbeitet werden.

Es ist auch denkbar, dass das Trägerband aus einem thermisch leitfähigen und elektrisch isolierenden Kunststoff gebildet ist, der zu einem vorzugsweise flexiblen Endlosband verarbeitet ist.

Bevorzugt sind die Wannen in einem vorzugsweise aus Aluminium bestehenden vorzugsweise ununterbrochenen Wannenband ausgebildet, wobei das Wannenband auf der Oberseite des Trägerbandes angeordnet und mit diesem fest verbunden ist. Für den Fall, dass das Wannenband aus Aluminium besteht, kann auf einfache Art und Weise die reflektierende Fläche auf der vom Trägerband abgewandten Seite bewerkstelligt werden. Für den Fall, dass das Wannenband aus einem nicht reflektierenden Material gebildet ist, kann durch einen Beschichtungsprozess eine reflektierende Schicht auf der Oberseite des Wannenbandes aufgebracht werden.

Vorzugsweise erfolgt die Befestigung des Wannenbandes auf der Oberseite des Trägerbandes mit einem thermisch leitfähigen Kleber, der eine thermische Ausdehnung zwischen jener des Isolierbandes und jener des Wannenbandes hat, um die thermischen ebenso wie die mechanischen Spannungen zwischen dem Wannenband und der Oberseite des Trägerbandes so klein wie möglich zu halten. Ansonsten bestünde die Gefahr, dass sich das Wannenband, insbesondere die Wannen, von der Oberseite des Trägerbandes ablösen.

Alternativ ist es auch denkbar, dass für den Fall, dass das Trägerband als thermisch leitfähiger und elektrisch isolierender Kunststoff ausgebildet ist, die Oberseite des Trägerbandes selbst mit Wannen ausgebildet ist, und die Wannen entsprechend teilweise oder vollständig mit einer reflektierenden Schicht z.B. einer Aluminiumschicht beschichtet sind.

Bevorzugt sind im Wannenband auf der dem Trägerband abgewandten Seite vorzugsweise durch Sicken gebildete Erhebungen ausgebildet, wobei jede Wanne von einer dieser Erhebungen umfangseitig begrenzt ist. Dies hat den Vorteil, dass der mindestens eine LED Chip in der Wanne durch die Erhebung einerseits geschützt ist und anderseits weisen die begrenzenden Erhebungen vorzugsweise einen trapezförmigen Querschnitt auf, so dass die Innenflächen der Wanne einen optimalen Winkel zum Abstrahlwinkel des LED Chips aufweisen, wodurch die verbesserte Lichtausbeute in jeder Wanne erzielbar ist.

In vorteilhafter Weise, kann das Wannenband grossflächig mit dem Trägerband fest verbunden werden, was zu einer guten Stabilität und Wärmeabfuhr beiträgt.

Bevorzugt ist jede eine Wanne begrenzende Erhebung vorzugsweise an einander gegenüberliegenden Seiten sowie vorzugsweise quer zur Längsrichtung unterbrochen und durch die betreffenden Unterbrüche verläuft jeweils eine elektrische Speiseleiterbahn oder eine Serienschaltungsleiterbahn. Dies hat den Vorteil, dass auf einfache Art und Weise der Zugang von den elektrischen Speiseleiterbahnen oder Serienschaltungsleiterbahnen zum mindestens einen LED Chip in der Wanne ermöglicht wird. Ausserdem können die elektrischen Speiseleiterbahnen bzw. Serienschaltungsleiterbahnen dadurch auf gleicher Höhe wie der mindestens eine LED Chip angeordnet werden, um vorzugsweise kurze Wege für die elektrischen Verbindungen zu ermöglichen.

Bevorzugt sind die Unterbrüche in den Erhebungen mittels eines Barrierematerials vorzugsweise aus Epoxi oder besonders bevorzugt aus Silikon geschlossen. Dies hat den Vorteil, dass die Wannen umfangseitig geschlossen sind, während in vorteilhafter Weise die elektrischen Speiseleiterbahnen oder Serienschaltungsleiterbahnen den betreffenden LED Chips in den Wannen zugeordnet sind.

Bevorzugt umfasst das LED Lichtband einen Flexprint, welcher für jede Wanne eine Ausnehmung sowie die Speiseleiterbahnen und die Serienschaltungsleiterbahnen aufweist; vorzugsweise sind aufeinanderfolgende Serienschaltungsleiterbahnen im seitlichen Wechsel bezüglich der betreffenden Ausnehmungen angeordnet. Der Flexprint ist vorzugsweise als gestanztes Verbundmaterial ausgebildet, wobei das Verbundmaterial eine auf der Oberseite einer Metallfolie aufgebrachte Isolationsschicht aufweist. Durch bekannte Belichtungsverfahren, können entsprechend die elektrischen Speiseleiterbahnen und Serienschaltungsleiterbahnen auf der Oberseite des Flexprints strukturiert werden.

Die Ausnehmungen im Flexprint sind vorzugsweise an die Erhebungen der Wannen angepasst und insbesondere die den LED Chips zugeordneten elektrischen Speiseleiterbahnen oder Serienschaltungsleiterbahnen auf dem Flexprint stehen in die Ausnehmungen vor und verlaufen durch die Unterbrüche in den Erhebungen der Wannen.

Bevorzugt ist das Leuchtstoffmaterial in jeder Wanne angeordnet. Besonders bevorzugt füllt das Leuchtstoffmaterial die Wannen aus. In diesem Zusammenhang verhindert insbesondere das Barrierematerial, dass das Leuchtstoffmaterial nicht durch die Unterbrüche in den Erhebungen herausfliessen kann.

Weiter besonders bevorzugt besteht das Leuchtstoffmaterial aus einer Silikon-Phosphor-Mischung, wobei eine Vielzahl von Phosphorpartikel in ein Silikongel eingebettet sind. Das Silikon hat die Aufgabe der Kühlung des mindestens einen LED Chips und die Phosphorpartikel verändern die Wellenlänge des emittierten Lichtes der LED Chips.

Vorzugsweise erfolgt die Charakterisierung der Farbe der LED Chips durch das Hot-Binning-Verfahren. Entsprechend werden die Farben jedes LED Chips bei Betriebstemperatur von ca. 85°C spezifiziert, weil sich insbesondere der Farbort eines LED Chips zwischen Raumtemperatur von ca. 25°C und der Betriebstemperatur von ca. 85°C unterscheidet.

Bevorzugt bilden die jeweils in Serie geschalteten LED Chips je eine LED Gruppe und die der LED Gruppe zugeordneten Wannen sind in einer, vorzugsweise in Längsrichtung verlaufenden und vorzugsweise geradlinigen Reihe aufeinanderfolgend angeordnet.

Bevorzugt sind LED Gruppen in Längsrichtung aufeinander folgend angeordnet und jede dieser LED Gruppen zusammen mit den zugeordneten und in Querrichtung verlaufenden positiven und negativen Speiseleiterbahnen definiert einen LED Lichtbandabschnitt. Dies hat den Vorteil, dass jeder LED Lichtbandabschnitt unabhängig vom dahinter bzw. davor angeordneten LED Lichtbandabschnitt elektrisch versorgt werden kann. Entsprechend kann jedem LED Lichtbandabschnitt ein entsprechendes Speisegerät zugeordnet werden, um die LED Chips der betreffenden LED Gruppe elektrisch zu speisen.

Besonders bevorzugt ist im LED Lichtbandabschnitt zur betreffenden LED Gruppe mindestens eine weitere LED Gruppe seitlich parallel angeordnet und parallel geschaltet. Dies hat den Vorteil, dass im LED Lichtbandabschnitt mindestens eine LED Gruppe und bevorzugt auch weitere LED Gruppen parallel angeordnet und parallel geschaltet werden können, um den LED Lichtbandabschnitt auszubilden. Die parallele Schaltung der LED Gruppen bedeutet hierbei, dass über die betreffende positive und negative Speiseleiterbahn problemlos mehrere LED Gruppen pro LED Lichtbandabschnitt mittels eines Speisegerätes gespeist werden können.

Bevorzugt sind die positiven und negativen Speiseleiterbahnanschlüsse auf derselben Seite des LED Lichtbandes angeordnet und sind jeweils mit einem auf derselben Seite des LED Lichtbandes angeordneten positiven bzw. negativen Speiseleiter verbunden. Dies hat den Vorteil, dass über die gesamte Länge des LED Lichtbandes auf einfache Art und Weise ununterbrochen eine elektrische Speisung der LED Chips mit einem Speisegerät möglich ist. Der betreffende Speiseleiter dient dabei als Schnittstelle zwischen den Speiseleiterbahnanschlüssen und dem Speisegerät.

Besonders bevorzugt sind die beiden Speiseleiter in der Abdeckung eingebettet. Dies hat den Vorteil, dass die Speiseleiter vor äusseren Einflüssen, insbesondere vor mechanischen Kräften, geschützt sind. Überdies sind die Speiseleiter in der Abdeckung vor Korrosion geschützt. Des Weiteren ermöglicht die transluzente bzw. transparente Eigenschaft der Abdeckung auf einfache Art und Weise die Zuordnung für ein Speisegerät zur Speisung der LED Chips in einem zugeordneten LED Lichtbandabschnitt.

Weiter kann die Abdeckung eine homogene Lichtabstrahlung unterstützen.

Bevorzugt sind LED Gruppen in Längsrichtung aufeinander folgend angeordnet und parallel geschaltet, wobei die diesen Gruppen zugeordnete gemeinsame positive Speiseleiterbahn auf der einen Seite und die diesen Gruppen zugeordnete gemeinsame negative Speiseleiterbahn auf der anderen Seite der Reihe von Wannen ununterbrochen das LED Lichtband durchlaufen und mindestens an einem Ende, vorzugsweise an beiden Enden jeder LED Gruppe einen positiven beziehungsweise negativen Speiseleiterbahnanschluss aufweisen, so dass jede dieser LED Gruppen zusammen mit den Speiseleiterbahnen und den zugeordneten Speiseleiterbahnanschlüssen einen LED Lichtbandabschnitt definiert. Diese bevorzugte Ausführungsform des Lichtbandes ermöglicht eine ununterbrochene und durchgehende elektrische Speisung der LED Chips pro Reihe von aufeinander nachfolgend angeordneten Wannen über das gesamte LED Lichtband hinweg.

Bevorzugt sind die Speiseleiterbahnanschlüsse jeweils beim Ende eines LED Lichtbandabschnittes angeordnet. Dies hat den Vorteil, dass ein Durchtrennen des LED Lichtbandes durch jeweils zwei LED Lichtbandabschnitte ermöglicht wird.

Besonders bevorzugt ist im LED Lichtbandabschnitt zur LED Gruppe mindestens eine weitere LED Gruppe mit eigenen Speiseleiterbahnen und zugeordneten Speiseleiterbahnanschlüssen seitlich parallel angeordnet. Dies hat den Vorteil, dass im LED Lichtbandabschnitt mindestens zwei LED Gruppen parallel angeordnet sind, welche individuell angespiessen werden können.

Bevorzugt ist das LED Lichtband zwischen jeweils zwei aufeinander folgenden LED Lichtbandabschnitten in Querrichtung durchtrennbar, um ein einen eigenständigen Beleuchtungskörper bildenden LED Lichtbandteil mit einer gewünschten Anzahl Lichtbandabschnitte zu erhalten. Durch das Abtrennen einer gewünschten Anzahl von LED Lichtbandabschnitten vom LED Lichtband kann eine gewünschte Länge des Beleuchtungskörpers erhalten werden. Die Durchtrennung eines LED Lichtbandabschnittes vom LED Lichtband ist nur möglich, weil die zugeordnete positive bzw. negative Speiseleiterbahn der betreffenden LED Gruppe zugeordnet ist, so dass jeder abgetrennte Beleuchtungskörper gebildete LED Lichtbandteil individuell und unabhängig von anderen LED Lichtbandabschnitten auf dem LED Lichtband mittels eines betreffenden Speisegerätes elektrisch gespeist werden kann.

Bevorzugt sind Lichtbandabschnitte mit nebeneinander angeordneten LED Gruppen zwischen den LED Gruppen in Längsrichtung durchtrennbar. Dies hat den Vorteil, dass jede LED Gruppe unabhängig von anderen LED Gruppen in Streifenform vorliegen kann, um an die Bedürfnisse des Anwenders angepasste Längen und Breiten eines Beleuchtungskörpers vom LED Lichtband zu erhalten.

Bevorzugt weist das Metallband des Trägerbandes seitlich aufgerichtete Seitenwände auf, welche in bestimmten Abständen unterbrochen sind, um eine Biegung zu vereinfachen. Dies hat den Vorteil, dass die dadurch erzielte Biegungsmöglichkeit des LED Lichtbandes die Befestigung des LED Lichtbandes an unebenen insbesondere gebogenen Oberflächen ermöglicht.

Bevorzugt weisen das Trägerband, das Wannenband und der Flexprint jeweils von der Oberseite zur Unterseite durchgehende, deckungsgleiche Perforationen oder in Querrichtung verlaufende Schlitze auf, um einerseits die gegenseitige Orientierung bei der Herstellung des LED Lichtbandes zu ermöglichen und andererseits die Torsionseigenschaften des LED Lichtbandes zu verbessern.

Weiter betrifft die vorliegende Erfindung ein Verfahren zur Herstellung eines LED Lichtbandes mit den nachfolgenden Schritten: bereitstellen eines eine Längsrichtung definierenden Trägerbandes mit einer Oberseite und einer Unterseite, wobei das Trägerband thermisch leitfähig und mindestens auf der Oberseite elektrisch isolierend ist; anordnen von Wannen auf der Oberseite, wobei die Wannen auf der vom Trägerband abgewandten Seite offen und reflektierend sind; anordnen mindestens jeweils eines LED Chips in den Wannen; anordnen elektrischer Speiseleiterbahnen und Serienschaltungsleiterbahnen, wobei Serienschaltungsleiterbahnen jeweils eine Anzahl der LED Chips zwischen einer positiven und einer negativen Speiseleiterbahn in Serie schalten, und die Speiseleiterbahnen Speiseleiterbahnanschlüsse aufweisen, die dazu bestimmt sind, eine Verbindung mit einem Speisegerät zu ermöglichen; anordnen eines Leuchtstoffmaterials in den Wannen, wobei das Leuchtstoffmaterial die Wellenlänge des emittierten Lichts der LED Chips verändert und anbringen einer transluzenten oder transparenten Abdeckung, welche die LED Chips und das Leuchtstoffmaterial vor äusseren Einflüssen schützt.

Bevorzugt umfasst das Verfahren den weiteren Schritt: durchtrennen des LED Lichtbandes zwischen zwei aufeinander folgenden LED Lichtbandabschnitten in Querrichtung, um ein einen eigenständigen Beleuchtungskörper bildenden LED Lichtbandteil mit einer gewünschten Anzahl Lichtbandabschnitte zu erhalten.

Weitere Vorteile und Eigenschaften des erfindungsgemässen LED Lichtbandes bzw. des erfindungsgemässen Verfahrens zur Herstellung des Lichtbandes gehen aus der nachstehenden Beschreibung von Ausführungsbeispielen hervor, welche anhand der Zeichnungen erläutert werden.

Es zeigen rein schematisch:
- Fig. 1: eine perspektivische Darstellung eines Ausschnitts einer ersten Ausführungsform eines erfindungsgemässen LED Lichtbandes, wobei in einem Ausschnitt A, die einzelnen Verfahrensschritte zur Herstellung des LED Lichtbandes und in einem Ausschnitt B, die Verbindung von Speiseleiterbahnanschlüssen mit zwei in einer transparenten oder transluzenten Abdeckung eingebettete Speiseleiter dargestellt sind;
- Fig. 2: eine vergrösserte Darstellung des Ausschnitts A gemäss Fig. 1;
- Fig. 3: eine vergrösserte Darstellung des Ausschnitts B gemäss Fig. 1;
- Fig. 4: eine Übersichtsdarstellung des LED Lichtbandes gemäss Fig. 1 mit Speisegeräten zur Speisung von zugeordneten LED Lichtbandabschnitten;
- Fig. 5: eine vergrösserte Darstellung des Ausschnitts C gemäss Fig. 4;
- Fig. 6: eine perspektivische und vergrösserte Darstellung der Fig. 4;
- Fig. 7: eine perspektivische Darstellung einer zweiten Ausführungsform eines erfindungsgemässen LED Lichtbandes mit einer Anzahl in Reihe hintereinander angeordneter LED Lichtbandabschnitte; und
- Fig. 8: eine vergrösserte Darstellung des Ausschnitts D gemäss Fig. 6, wobei ein vom LED Lichtband gemäss der zweiten Ausführungsform abgetrennter LED Lichtbandteil im Detail gezeigt ist.

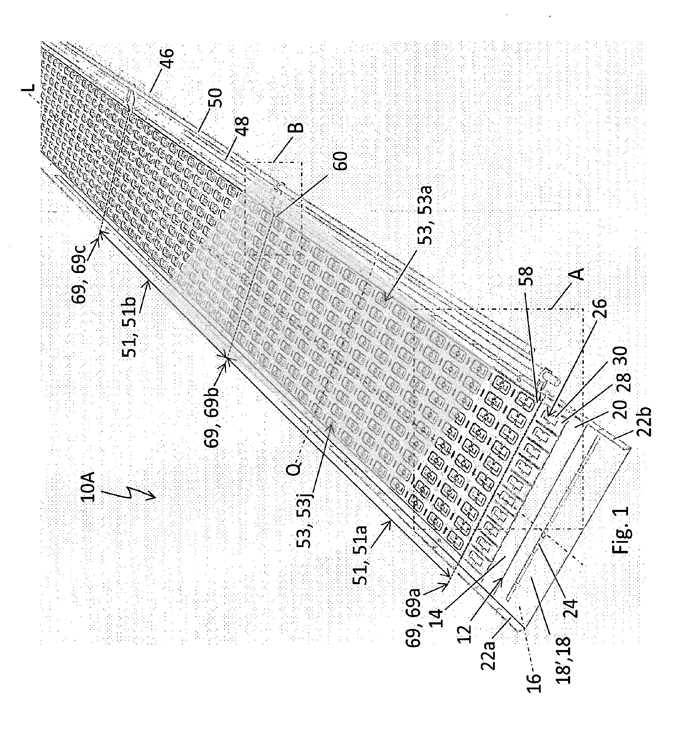

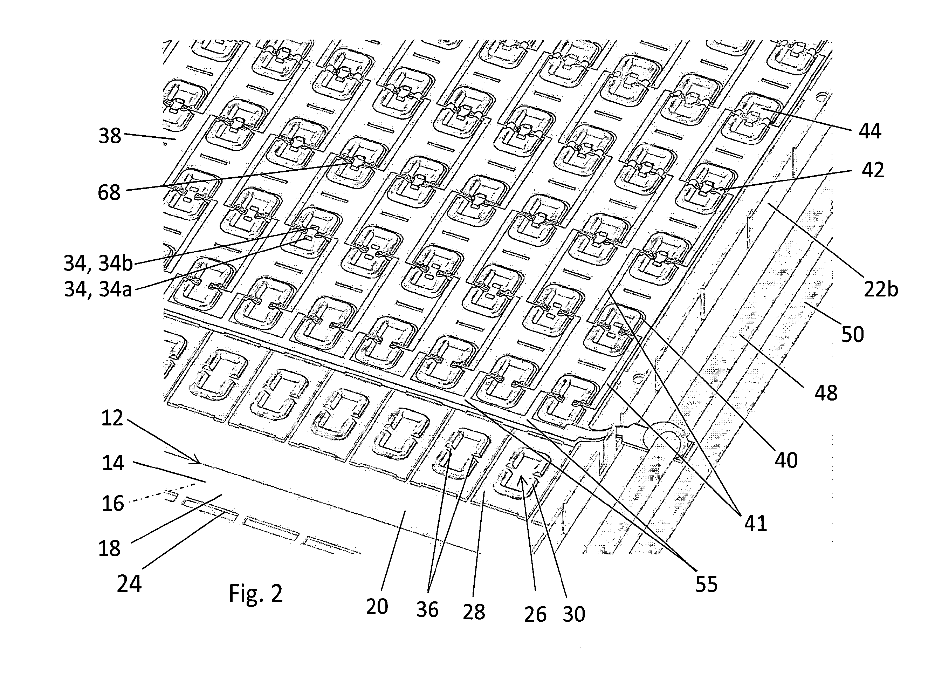

Mit Bezug auf den Ausschnitt A in Fig. 1 und die vergrösserte Darstellung in Fig. 2 weist ein LED Lichtband 10A gemäss einer ersten Ausführungsform ein eine Längsrichtung L definierendes Trägerband 12 mit einer Oberseite 14 und einer Unterseite 16 auf.

Das Trägerband 12 ist in vorliegendem Beispiel aus einem als Aluminiumband 18' ausgebildeten Metallband 18 und ein mit diesem fest verbundenen Isolierband 20 gebildet. Das Isolierband 20 hat thermisch leitfähige und elektrisch isolierende Eigenschaften.

Das Aluminiumband 18' weist eine linke und eine rechte seitlich aufgerichtete Seitenwand 22a, 22b auf, wobei diese Seitenwände 22a, 22b in bestimmten Abständen unterbrochen sind. Dies vereinfacht ein Biegen quer zur Mantelfläche des Aluminiumbandes 18'.

Überdies weisen das Aluminiumband 18' und das Isolierband 20 in Querrichtung Q von der Oberseite 14 zur Unterseite 16 des Trägerbandes 12 durchgehende Schlitze 24 auf. Diese Schlitze 24 dienen einerseits als Orientierung bei der Herstellung des LED Lichtbandes 10A und anderseits vereinfachen die Schlitze 24 ein Biegen quer zur Mantelfläche des Trägerbandes 12.

In vorliegendem Ausführungsbeispiel, gemäss Fig. 1, sind auf der Oberseite 14 des Isolierbandes 20 zehn Wannen 26 in Querrichtung Q und eine Vielzahl von Wannen 26 in Längsrichtung L aufeinander nachfolgend angeordnet. Die Wannen 26 sind auf der vom Trägerband 12 abgewandten Seite offen und reflektierend.

Gemäss Fig. 2 ist jede Wanne 26 in einem aus Aluminium bestehenden Wannenband 28 ausgebildet. Das Wannenband 28 ist auf der Oberseite 14 des Isolierbandes 20 angeordnet und mit diesem fest verbunden. Vorzugsweise erfolgt die Befestigung des Wannenbandes 28 auf der Oberseite 14 des Isolierbandes 20 mit einem thermisch leitfähigen Kleber, wobei die thermische Ausdehnung des Klebers zwischen jener des Wannenbandes 28 und jener des Isolierbandes 20 liegt, um thermische Spannungen ebenso wie mechanische Schichtspannungen so klein wie möglich zu halten.

Im Wannenband 28 sind auf der dem Trägerband 12 abgewandten Seite vorzugsweise durch Sicken gebildete gerundet rechteckige oder O-förmige Erhebungen 30 ausgebildet. Hierbei ist jede Wanne 26 von einer dieser Erhebungen 30 umfangseitig begrenzt.

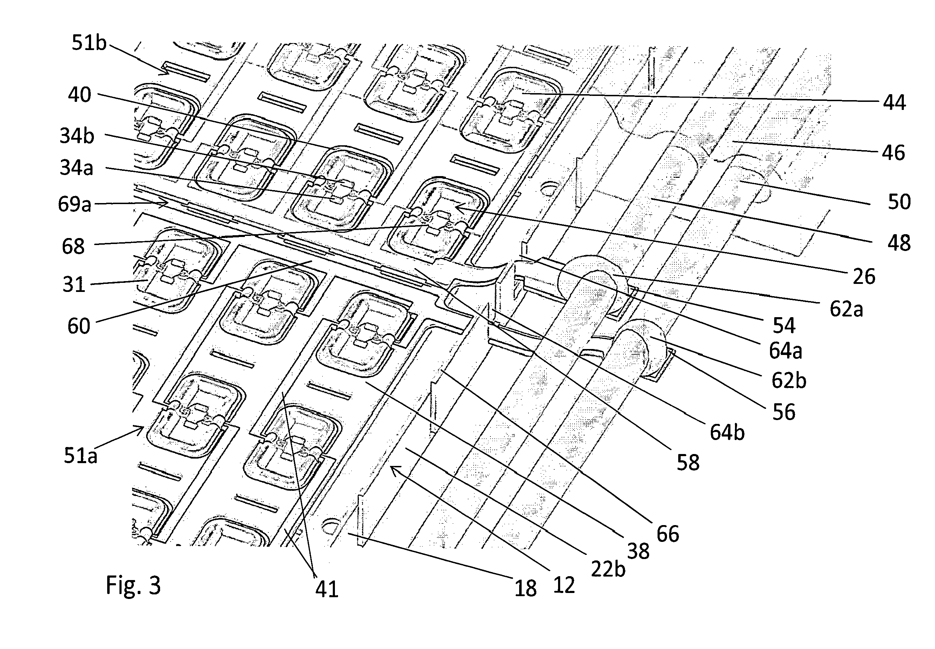

Jede Erhebung 30 ist, wie in Fig. 2 und Fig. 3 jeweils vergrössert gezeigt, im Querschnitt annährend trapezförmig ausgebildet, so dass insbesondere die Innenflächen 31 jeder Wanne 26 angrenzend an den ebenen Wannenboden eine schräge reflektierende Ebene ausbilden. Diese schrägen Innenflächen 31 ermöglichen die Lichtreflexion des emittierten Lichts von einem LED Chip in Richtung der Öffnung der Wanne 26. Überdies ist jede Erhebung 30 quer zur Längsrichtung L an aneinander gegenüberliegenden Seiten unterbrochen. Durch die betreffenden Unterbrüche 36 verläuft jeweils eine elektrische Speiseleiterbahn 58, 60 oder eine Serienschaltungsleiterbahn 41.

Gemäss Fig. 2 sind die elektrischen Speiseleiterbahnen 58, 60 und die Serienschaltungsleiterbahnen 41 auf einem Flexprint 38 strukturiert und der Felxprint 38 weist Ausnehmungen 40 auf, die den Wannen 26 zugeordnet sind. Der Flexprint 38 ist auf der Oberseite des Wannenbandes 28 angeordnet und mit diesem fest verbunden beispielsweise verklebt, wobei die Erhebungen 30 der Wannen 26 durch die Ausnehmungen 40 des Flexprints 38 hervor stehen.

Aufeinanderfolgende Serienschaltungsleiterbahnen 41 sind im seitlichen Wechsel bezüglich der betreffenden Ausnehmungen 40 angeordnet.

Gemäss Fig. 2 sind zwei parallelgeschaltete LED Chips 34a, 34b in jeder Wanne 26 auf der Oberseite des Wannenbandes 28 befestigt. Vorzugsweise wird zur Befestigung der LED Chips 34 auf der Oberseite des Wannenbandes 28 ein transparenter Kleber verwendet.

Bei den LED Chips 34 handelt es sich hier um einen III-V Halbleiter der als pn-Leuchtdiode ausgebildet ist und zwischen der p-Schicht sowie der n-Schicht eine Sperrschicht aufweist. Das Material der LED Chips 34 ist transluzent und ermöglicht eine Abstrahlung des emittierten Lichts in alle Richtungen, wobei wegen der unterschiedlichen Brechungsindizes vom pn-Material und der Sperrschicht der Abstrahlwinkel von der Sperrschicht im Zentrum des LED Chips 34 zur Aussenfläche des LED Chips 34 um die 120° beträgt.

Durch die reflektierende Oberfläche des Wannenbandes 28 beziehungsweise der Wannen 26 kann das in Richtung zum Trägerband 12 emittierte Licht wieder in das LED Material zurück reflektiert werden und entsprechend auf der Oberseite des LED Chips 34 austreten. Dies führt entsprechend zu einer erhöhten Lichtausbeute. Auch das emittierte Licht, welches an den Seitenwänden des LED Chips 34 austritt, kann genutzt werden, da dieses Licht an der schrägen Innenfläche 31 der Erhebung 30 der Wanne 26 nach oben reflektiert wird. Mit der Anordnung der LED Chips 34 in der reflektierenden Wanne 26 wird somit eine hohe Lichtausbeute erzielt und zudem ein homogener Lichteindruck für das LED Lichtband 10A erzeugt.

Gemäss Fig. 2 sind die elektrischen Speiseleiterbahnen 58, 60 oder Serienschaltungsleiterbahnen 41, die durch die betreffenden Unterbrüche 36 der Erhebungen 30 verlaufen, in der betreffenden Wanne 26 den betreffenden beiden LED Chips 34a, 34b zugeordnet. Die elektrische Verbindung zwischen den betreffenden elektrischen Speiseleiterbahnen 58, 60 oder Serienschaltungsleiterbahnen 41 mit den betreffenden LED Chips 34 erfolgt durch Drahtbonden 68. In vorliegendem Beispiel sind die beiden LED Chips 34a, 34b in jeder Wanne 26 parallel geschaltet.

Gemäss Fig. 2 verschliesst ein vorzugsweise aus Epoxi oder besonders bevorzugt aus Silikon gebildetes Barrierematerial 42 die Unterbrüche 36 in den Erhebungen 30, so dass die betreffenden Wannen 26 mit einem Leuchtstoffmaterial 44 befüllt werden können, ohne dass dabei das Leuchtstoffmaterial 44 durch die Unterbrüche 36 herauszufliessen kann.

Vorzugsweise besteht das Leuchtstoffmaterial 44 aus einer Silikon-Phosphor-Mischung, wobei eine Vielzahl von Phosphorpartikel in ein Silikongel eingebettet ist.

Wie im Ausschnitt B der Fig. 1 und in Fig. 3 in der vergrösserten Darstellung gezeigt, sind die LED Chips 34 und das Leuchtstoffmaterial 44 durch eine flächige Abdeckung 46 vor äusseren Einflüssen geschützt.

Die Abdeckung 46 ist aus transluzentem oder transparentem Material gebildet. Besonders bevorzugt ist die Abdeckung 46 aus Silikon gebildet. Durch ein Extrudierverfahren ist die Abdeckung 46 aus Silikon über dem Leuchtstoffmaterial 44 angespritzt und überdeckt bevorzugt das gesamte LED Lichtband 10A mindestens auf der Oberseite.

Das LED Lichtband 10A ist auf die oben beschriebenen Art und Weise hergestellt und jede mit dem Leuchtstoffmaterial 44 befüllte und mit den zugeordneten LED Chips 34 versehene Wanne 26 bildet zusammen mit den zugeordneten Speiseleiterbahnen 58, 60 oder Serienschaltungsleiterbahnen 41 sowie der Abdeckung 46 eine sogenannte optische Einheit aus.

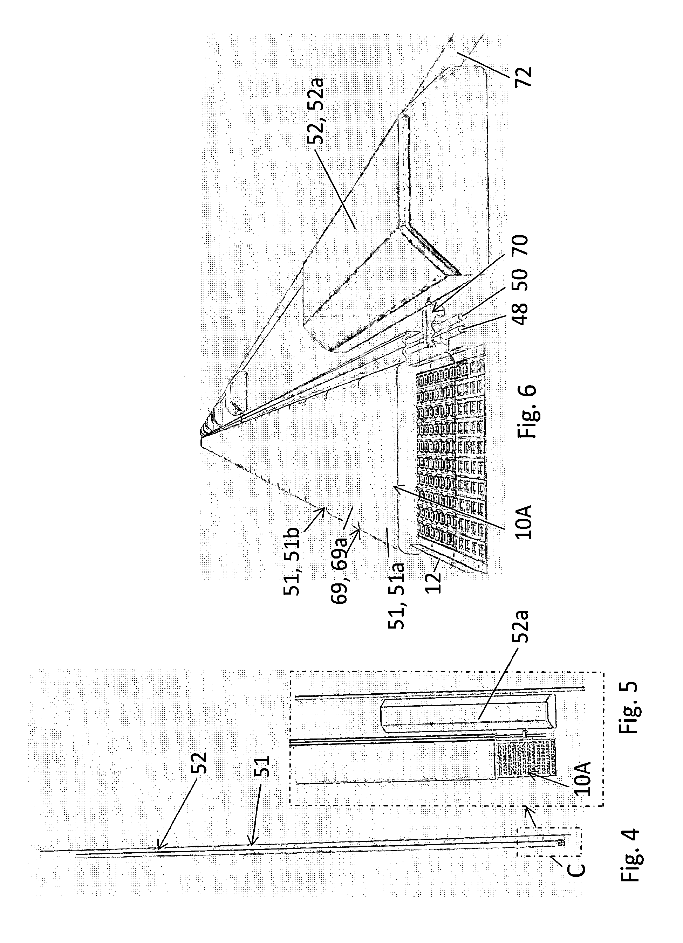

Gemäss Fig. 1 bis Fig. 3 verlaufen ein positiver Speiseleiter 48 und ein negativer Speiseleiter 50 gemeinsam auf dergleichen Seite des Trägerbandes 12 in dessen Längsrichtung L. Dabei sind auch der positive Speiseleiter 48 und der negative Speiseleiter 50 in der Abdeckung 46 aus Silikon eingebettet. Dies hat den Vorteil, dass die beiden Speiseleiter 48, 50 vor mechanischen Kräften und äusseren Einflüssen, insbesondere gegen Korrosion, geschützt sind. Die beiden Speiseleiter 48, 50 sind dazu bestimmt, mit einem Speisegerät 52, wie in Fig. 4 und Fig. 5 gezeigt, zusammenzuwirken, worauf später genauer eingegangen wird.

Gemäss Fig. 1 und Fig. 3 definieren fünfzehn in einer in Längsrichtung L verlaufenden Reihe aufeinander nachfolgend angeordneter Wannen 26 die Länge eines LED Lichtbandabschnitts 51. Die Serienschaltungsleiterbahnen 41 schalten jeweils die LED Chips 34 in den betreffenden fünfzehn Wannen 26a-26o in Serie. Der LED Chip 34 in der ersten Wanne 26a und der letzte LED Chip 34 in der letzten Wanne 26o ist jeweils mit einer zugeordneten positiven bzw. negativen Speiseleiterbahn 58, 60 verbunden.

Die jeweils in Serie geschalteten LED Chips 34 bilden je eine LED Gruppe 53 aus und die der LED Gruppe 53 zugeordneten Wannen 26 sind in einer in Längsrichtung L verlaufenden und geradlinigen Reihe aufeinanderfolgend angeordnet.

LED Gruppen 53 sind in Längsrichtung L aufeinander folgend angeordnet und jede dieser LED Gruppen 53 zusammen mit den zugeordneten und in Querrichtung Q verlaufenden positiven und negativen Speiseleiterbahnen 58, 60 definieren den LED Lichtbandabschnitt 51.

In vorliegendem Beispiel, gemäss Fig. 1, sind im LED Lichtbandabschnitt 51 zur ersten LED Gruppe 53a neun weitere LED Gruppen 53b-53j seitlich parallel angeordnet und parallel geschaltet. Entsprechend weist jeder LED Lichtbandabschnitt 51 gemäss der ersten Ausführungsform des erfindungsgemässen LED Lichtbandes 10A ein 10 x 15 Wannen-Array auf der Oberseite des Isolierbandes 20 auf.

Die in Längsrichtung L verlaufenden Reihe und aufeinander nachfolgend angeordneten LED Lichtbandabschnitte 51 bilden das LED Lichtband 10A aus.

Die einzelnen LED Lichtbandabschnitte 51 des LED Lichtbandes 10A können zwischen jeweils zwei aufeinander folgenden LED Lichtbandabschnitten 51a, 51b in Querrichtung Q durchtrennt werden, um ein einen eigenständigen Beleuchtungskörper bildenden LED Lichtbandteil mit einer gewünschten Anzahl Lichtbandabschnitte 51 zu erhalten. Dies erfolgt an Übergängen 69 der betreffenden LED Lichtbandabschnitte 51a, 51b wie in Fig. 1 gezeigt. Dabei endet, wie in Fig. 3 gezeigt, der erste LED Lichtbandabschnitt 51a am oberen Ende der ersten LED Gruppe 53a mit der negativen Speiseleiterbahn 60 und der in Längsrichtung L nachfolgende LED Lichtbandabschnitt 51b beginnt am unteren Ende der nächsten LED Gruppe 53b mit der positiven Speiseleiterbahn 58. Diese Übergänge 69 können durch entsprechende Markierungen (siehe Fig. 6) auf der Abdeckung 46 gekennzeichnet sein, um die Abtrennung des betreffenden LED Lichtbandteils vom LED Lichtband 10A am richtigen Ort zu ermöglichen.

Gemäss Fig. 3 sind zur Speisung der LED Chips 34 der LED-Gruppen 53 im betreffenden LED Lichtbandabschnitt 51 die positive Speiseleiterbahn 58 über den positiven Speiseleiterbahnanschluss 54 mit dem positiven Speiseleiter 48 und die negative Speiseleiterbahn 60 über den negativen Speiseleiterbahnanschluss 56 mit dem negativen Speiseleiter 50 elektrisch verbunden.

Eine Löststelle 62a verbindet den positiven Speiseleiterbahnanschluss 54 mit dem positiven Speiseleiter 48 und eine weitere Lötstelle 62b verbindet den negativen Speiseleiterbahnanschluss 56 mit dem negativen Speiseleiter 50.

Der positive Speiseleiterbahnanschluss 54 und der negative Speiseleiterbahnanschluss 56 sind auf dem Flexprint 38 strukturiert und durch Seitenwandunterbrüche 64a, 64b in der rechten Seitenwand 22b des Aluminiumbandes 18 zum positiven Speiseleiter 48 und negativen Speiseleiter 50 hindurchgeführt.

Damit der positive Speiseleiterbahnanschluss 54 und der negative Speiseleiterbahnanschluss 56 sich im Bereich der beiden Speiseleiter 48, 50 nicht überkreuzen, ist der negative Speiseleiterbahnanschluss 56 unterhalb des positiven Speiseleiterbahnanschlusses 54 und dem positiven Speiseleiter 48 geführt. Dies ist insbesondere wegen der flexiblen Eigenschaft des Flexprints 38 möglich. Überdies ist der Seitenwandunterbruch 64a der rechten Seitenwand 22b von deren Oberkante 66 weniger tief unterbrochen als der weitere Seitenwandunterbruch 64b.

Die elektrische Speisung der einzelnen in Reihe hintereinander angeordneten LED Lichtbandabschnitte 51 des LED Lichtbandes 10A mit dem zugeordneten Speisegerät 52 ist in Fig. 4 und Fig. 6 im Überblick gezeigt und eine Vergrösserung des Ausschnitts C gemäss Fig. 4 betreffend des ersten LED Lichtbandabschnitts 51a zusammen mit einem ersten Speisegerät 52a ist in Fig. 5 gezeigt.

Gemäss Fig. 4 und Fig. 6 ist jedem LED Lichtbandabschnitt 51 auf dem LED Lichtband 10A ein betreffendes Speisegerät 52 zugeordnet, wobei mittels Messerkontakten (nicht sichtbar) einer Kontaktierungsvorrichtung 70 (siehe Fig. 6) die elektrische Verbindung des positiven Speiseleiters 48 und des negativen Speiseleiters 50 mit dem betreffenden Speisegerät 52 erfolgt.

Die Speisegeräte 52 sind in vorliegendem Beispiel zusammen mit dem Trägerband 12 des LED Lichtbandes 10 auf einem Endlosband 72 in Reihe aufeinander nachfolgend angeordnet. Somit kann am Übergang 69 zwischen zwei LED Lichtbandabschnitten 51a, 51b zur Abtrennung des gewünschten LED Lichtbandteils zusammen auch das betreffende Speisegerät 52 abgetrennt werden.

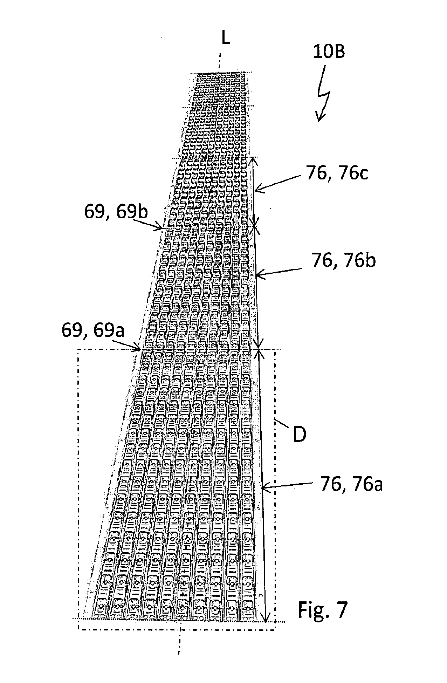

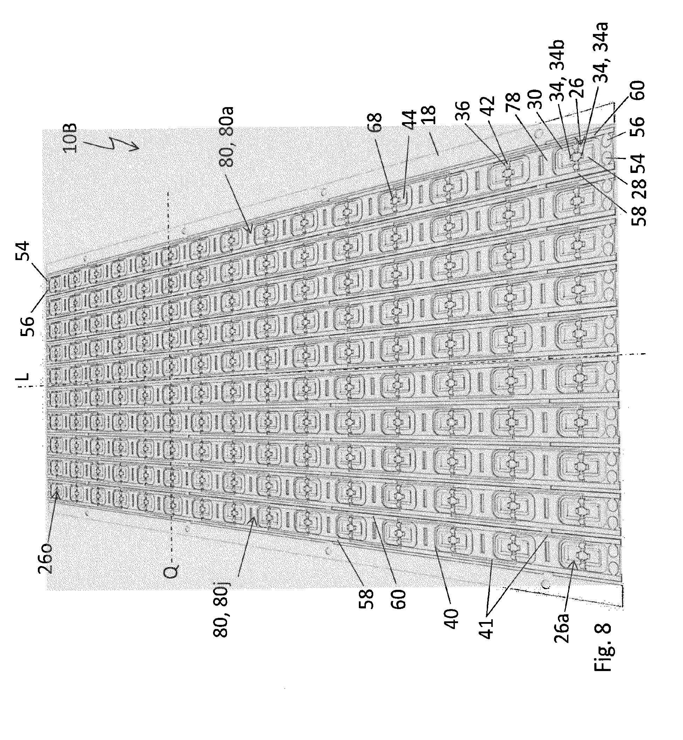

Gemäss Fig. 7 und Fig. 8 ist eine zweite Ausführungsform des erfindungsgemässen LED Lichtbandes 10B ohne Trägerband und ohne Abdeckung gezeigt. Es werden für die gleichen Bauteile die gleichen Bezugszeichen verwendet, wie oben im Zusammenhang mit der ersten Ausführungsform beschrieben und auf den Fig. 1 bis Fig. 3 gezeigt.

Da die zweite Ausführungsform des erfindungsgemässen LED Lichtbandes 10B gleich aufgebaut ist wie die in Fig. 1 bis 3 beschriebenen erste Ausführungsform des erfindungsgemässen LED Lichtbandes lOB, wird im nachfolgenden nur auf die Unterschiede zwischen den beiden LED Lichtband Ausführungsformen 10A, 10B eingegangen.

Im Unterschied zur ersten Ausführungsform des LED Lichtbandes 10A handelt es sich bei der zweiten Ausführungsform des LED Lichtbandes 10B um eine andere elektrische Verschaltung der LED Chips 34 sowie deren Verbindung zum Speisegerät 52.

Gemäss Fig. 7 bilden die in Längsrichtung L in einer Reihe aufeinander nachfolgend angeordneten LED Lichtbandabschnitte 76 das LED Lichtband 10B gemäss der zweiten Ausführungsform aus. Entsprechend können die einzelnen LED Lichtbandabschnitte 76 des LED Lichtbandes 10B zwischen zwei aufeinander folgenden LED Lichtbandabschnitten 76a, 76b in Querrichtung Q an den Übergängen 69 durchtrennt werden, um ein einen eigenständigen Beleuchtungskörper bildenden LED Lichtbandteil mit einer gewünschten Anzahl LED Lichtbandabschnitte 76 zu erhalten. Die Abtrennung am LED Lichtband 10B kann beispielsweise an einem ersten Übergang 69a oder einem weiteren Übergang 69b erfolgen, um die gewünschte Länge des LED Lichtbandteils zu erhalten.

In Fig. 8 ist ein abgetrennter LED Lichtbandteil dargestellt, der gemäss Fig. 7 am ersten Übergang 69a vom weiteren LED Lichtband 10B durchtrennt wurde.

Die Serienschaltung von den jeweils in fünfzehn Wannen 26 angeordneten LED Chips 34 ist in gleicher Art und Weise ausgeführt wie oben im Zusammenhang mit der ersten Ausführungsform des LED Lichtbandes 10A beschrieben. Hinsichtlich der elektrischen Verschaltung bilden die jeweils in Serie geschalteten LED Chips 34 je eine LED Gruppe 80 gemäss der zweiten Ausführungsform des erfindungsgemässen LED Lichtbandes 10B aus und die der LED Gruppe 80 zugeordneten Wannen 26 sind in einer in Längsrichtung L verlaufenden und geradlinigen Reihe aufeinanderfolgend angeordnet.

In vorliegendem Beispiel, gemäss Fig. 8, sind LED Gruppen 80 parallel geschaltet, wobei die diesen Gruppen 80 zugeordnete gemeinsame positive Speiseleiterbahn 58 auf der einen Seite und die diesen Gruppen 80 zugeordnete gemeinsame negative Speiseleiterbahn 60 auf der anderen Seite der Reihe von Wannen 26 ununterbrochen das LED Lichtband 10B durchlaufen. An beiden Enden jeder LED Gruppe 80 ist jeweils ein positiver beziehungsweise negativer Speiseleiterbahnenanschluss 54, 56 angeordnet. Auf diese Art und Weise ist es möglich ein Speisegerät entweder am einen Ende oder am anderen Ende des LED Lichtbandes 10B anzuordnen.

Jede dieser LED Gruppen 80 definiert zusammen mit den Speiseleiterbahnen 58, 60 und den zugeordneten Speiseleiterbahnanschlüssen 54, 56 den LED Lichtbandabschnitt 76 gemäss der zweiten Ausführungsform des LED Lichtbandes 10B.

Im LED Lichtbandabschnitt 76 sind zur ersten LED Gruppe 80a neun weitere LED Gruppen 80b-80h mit eigenen Speiseleiterbahnen 58, 60 und zugeordneten Speiseleiterbahnanschlüssen 54, 56 seitlich parallel angeordnet.

Gemäss der zweiten Ausführungsform des erfindungsgemässen

LED Lichtbandes 10B sind LED Lichtbandabschnitte 76 mit nebeneinander angeordneten LED Gruppen 80 zwischen den LED Gruppen 80 in Längsrichtung L abtrennbar. Auf diese Art und Weise ist es möglich, streifenförmige LED Lichtbandteile unterschiedlicher Breite zu erhalten.

## Patentansprüche

1. LED Lichtband aufweisend:
ein eine Längsrichtung (L) definierendes Trägerband (12) mit einer Oberseite (14) und einer Unterseite (16), wobei das Trägerband (12) thermisch leitfähig und mindestens auf der Oberseite (14) elektrisch isolierend ist;
auf der Oberseite (14) angeordnete Wannen (26), welche auf der vom Trägerband (12) abgewandten Seite offen und reflektierend sind;
mindestens jeweils einen in den Wannen (26) angeordneten LED Chip (34);
elektrische Speiseleiterbahnen (58, 60) und Serienschaltungsleiterbahnen (41), wobei Serienschaltungsleiterbahnen (41) jeweils eine Anzahl der LED Chips (34) zwischen einer positiven und einer negativen Speiseleiterbahn in Serie schalten, und die Speiseleiterbahnen (58, 60) Speiseleiterbahnanschlüsse (54, 56) aufweisen, die dazu bestimmt sind, eine Verbindung mit einem Speisegerät (52) zu ermöglichen;
ein Leuchtstoffmaterial (44), welches die Wellenlänge des emittierten Lichts der LED Chips (34) verändert; und
eine transluzente oder transparente Abdeckung (46), welche die LED Chips (34) und das Leuchtstoffmaterial (44) vor äusseren Einflüssen schützt.

2. LED Lichtband nach Anspruch 1, **dadurch gekennzeichnet, dass** das Trägerband (12) ein vorzugsweise aus Aluminium gebildetes Metallband (18) und eine mit diesem fest verbundene, vorzugsweise durch ein Isolierband (20) gebildete, die Oberseite bildende elektrische Isolationsschicht aufweist.

3. LED Lichtband nach Anspruch 1 oder 2, **dadurch gekennzeichnet, dass** die Wannen (26) in einem vorzugsweise aus Aluminium bestehenden Wannenband (28) ausgebildet sind, wobei das Wannenband (28) auf der Oberseite (14) des Trägerbandes (12) angeordnet und mit diesem fest verbunden ist.

4. LED Lichtband nach Anspruch 3, **dadurch gekennzeichnet, dass** im Wannenband (28) auf der dem Trägerband (12) abgewandten Seite vorzugsweise durch Sicken gebildete Erhebungen (30) ausgebildet sind, wobei jede Wanne (26) von einer dieser Erhebungen (30) umfangsseitig begrenzt ist.

5. LED Lichtband nach Anspruch 4, **dadurch gekennzeichnet, dass** jede eine Wanne (26) begrenzende Erhebung (30) vorzugsweise an einander gegenüberliegenden Seiten sowie vorzugsweise quer zur Längsrichtung (L) unterbrochen ist und durch die betreffenden Unterbrüche (36) jeweils eine elektrische Speiseleiterbahn (58, 60) oder eine Serienschaltungsleiterbahn (41) verläuft.

6. LED Lichtband nach Anspruch 5, **dadurch gekennzeichnet, dass** die Unterbrüche (36) in den Erhebungen (30) mittels eines Barrierematerials (42) geschlossen sind.

7. LED Lichtband nach einem der Ansprüche 1 bis 6, **gekennzeichnet durch** einen Flexprint (38), welcher für jede Wanne (26) eine Ausnehmung (40) sowie die Speiseleiterbahnen (58, 60) und die Serienschaltungsleiterbahnen (41) aufweist, und vorzugsweise aufeinanderfolgende Serienschaltungsleiterbahnen (41) im seitlichen Wechsel bezüglich der betreffenden Ausnehmungen (40) angeordnet sind.

8. LED Lichtband nach einem der Ansprüche 1 bis 7, **dadurch gekennzeichnet, dass** das Leuchtstoffmaterial (44) in den Wannen (26) angeordnet ist, bevorzugt die Wannen (26) ausfüllt, und vorzugsweise aus einer Silikon-Phosphor-Mischung besteht, wobei eine Mehrzahl von Phosphorpartikeln in ein Silikongel eingebettet sind.

9. LED Lichtband nach einem der Ansprüche 1 bis 8, **dadurch gekennzeichnet, dass** die jeweils in Serie geschalteten LED Chips (34) je eine LED Gruppe (53, 80) bilden und die der LED Gruppe (53, 80) zugeordneten Wannen (26) in einer, vorzugsweise in Längsrichtung (L) verlaufenden und vorzugsweise geradlinigen Reihe aufeinanderfolgend angeordnet sind.

10. LED Lichtband nach Anspruch 9, **dadurch gekennzeichnet, dass** LED Gruppen (53) in Längsrichtung (L) aufeinander folgend angeordnet sind und jede dieser LED Gruppen (53) zusammen mit den zugeordneten und in Querrichtung (Q) verlaufenden positiven und negativen Speiseleiterbahnen (58, 60) einen LED Lichtbandabschnitt (51) definiert, und vorzugsweise im LED Lichtbandabschnitt (51) zur betreffenden LED Gruppe (53a) mindestens eine weitere LED Gruppe (53b) seitlich parallel angeordnet und parallel geschaltet ist.

11. LED Lichtband nach Anspruch 10, **dadurch gekennzeichnet, dass** die positiven und negativen Speiseleiterbahnanschlüsse (54, 56) auf derselben Seite des LED Lichtbandes (10A) angeordnet sind und jeweils mit einem auf derselben Seite des LED Lichtbandes (10A) verlaufenden positiven bzw. negativen Speiseleiter (48, 50) verbunden sind, wobei vorzugsweise die beiden Speiseleiter (48, 50) in der Abdeckung (46) eingebettet sind.

12. LED Lichtband nach Anspruch 9, **dadurch gekennzeichnet, dass** LED Gruppen (80) in Längsrichtung (L) aufeinander folgend angeordnet und parallel geschaltet sind, wobei die diesen Gruppen zugeordnete gemeinsame positive Speiseleiterbahn (58) auf der einen Seite und die diesen Gruppen zugeordnete gemeinsame negative Speiseleiterbahn (60) auf der andern Seite der Reihen der Wannen (26) ununterbrochen das LED Lichtband (10B) durchlaufen und mindestens an einem Ende, vorzugsweise an beiden Enden jeder LED Gruppe (80) einen positiven beziehungsweise negativen Speiseleiterbahnanschluss (54, 56) aufweisen, so dass jede dieser LED Gruppen (80) zusammen mit den Speiseleiterbahnen (58, 60) und den zugeordneten Speiseleiterbahnanschlüssen (54, 56) einen LED Lichtbandabschnitt (76) definiert, und vorzugsweise im LED Lichtbandabschnitt (76) zur LED Gruppe (80a) mindestens eine weitere LED Gruppe (80b) mit eigenen Speiseleiterbahnen (58, 60) und zugeordneten Speiseleiterbahnanschlüssen (54, 56) seitlich parallel angeordnet ist.

13. LED Lichtband nach einem der Ansprüche 10 bis 12, **dadurch gekennzeichnet, dass** das LED Lichtband (10A; 10B) zwischen jeweils zwei aufeinander folgenden LED Lichtbandabschnitten (51a, 51b; 76a, 76b) in Querrichtung (Q) durchtrennbar ist, um ein einen eigenständigen Beleuchtungskörper bildenden LED Lichtbandteil mit einer gewünschten Anzahl Lichtbandabschnitte (51, 76) zu erhalten.

14. LED Lichtband nach Anspruch 13, **dadurch gekennzeichnet, dass** LED Lichtbandabschnitte (51, 76) mit nebeneinander angeordneten LED Gruppen (53, 80) zwischen den LED Gruppen (53, 80) in Längsrichtung (L) durchtrennbar sind.

15. Verfahren zur Herstellung eines LED Lichtbandes nach einem der Ansprüche 1 bis 14 mit den nachfolgenden Schritten:
bereitstellen eines eine Längsrichtung (L) definierenden Trägerbandes (12) mit einer Oberseite (14) und einer Unterseite (16), wobei das Trägerband (12) thermisch leitfähig und mindestens auf der Oberseite (14) elektrisch isolierend ist;
anordnen von Wannen (26) auf der Oberseite (14), wobei die Wannen (26) auf der vom Trägerband (12) abgewandten Seite offen und reflektierend sind;
anordnen mindestens jeweils eines LED Chips (34) in den Wannen (26);
anordnen elektrischer Speiseleiterbahnen (58, 60) und Serienschaltungsleiterbahnen (41), wobei Serienschaltungsleiterbahnen (41) jeweils eine Anzahl der LED Chips (34) zwischen einer positiven und einer negativen Speiseleiterbahn (58, 60) in Serie schalten, und die Speiseleiterbahnen (58, 60) Speiseleiterbahnanschlüsse (54, 56) aufweisen, die dazu bestimmt sind eine Verbindung mit einem Speisegerät (52) zu ermöglichen;
anordnen eines Leuchtstoffmaterials (44) in den Wannen (26), wobei das Leuchtstoffmaterial (44) die Wellenlänge des emittierten Lichts der LED Chips (34) verändert; und
anbringen einer transluzenten oder transparenten Abdeckung (46), welche die LED Chips (34) und das Leuchtstoffmaterial (44) vor äusseren Einflüssen schützt.

16. Verfahren nach Anspruch 15 umfassend den weiteren Schritt, durchtrennen des LED Lichtbandes (10A; 10B) zwischen zwei aufeinander folgenden LED Lichtbandabschnitten (51; 76) in Querrichtung (Q), um ein einen eigenständigen Beleuchtungskörper bildenden LED Lichtbandteil mit einer gewünschten Anzahl Lichtbandabschnitte (76) zu erhalten.
